# EUROPÄISCHE PATENTSCHRIFT

(11) **EP 3 440 695 B1**
(45) Veröffentlichungstag und Bekanntmachung des Hinweises auf die Patenterteilung: **02.10.2019**
(21) Anmeldenummer: 17715696.5
(22) Anmeldetag: 04.04.2017
(51) Int. Cl.: H01L 21/683, H01L 21/687, H01L 21/67

(54) **VERFAHREN UND VORRICHTUNG ZUM BONDEN ZWEIER SUBSTRATE**
METHOD AND APPARATUS FOR BONDING OF TWO SUBSTRATES
MÉTHODE ET APPAREIL POUR L'ENCOLLAGE DE DEUX SUBSTRATS

(30) Priorität: 07.04.2016 DE 102016106351
(43) Veröffentlichungstag der Anmeldung: 13.02.2019
(73) Patentinhaber: EV Group E. Thallner GmbH, St. Florian am Inn (AT)
(72) Erfinder: FEHKÜHRER, Andreas, 4973 Senftenbach (AT)
(74) Vertreter: Schneider, Sascha
(86) Internationale Anmeldenummer: PCT/EP2017/057969
(87) Internationale Veröffentlichungsnummer: WO 2017/174570

(56) Entgegenhaltungen:
- JP-A- 2007 242 552
- JP-A- 2013 084 950
- US-A1- 2005 029 224
- US-A1- 2009 218 560
- US-A1- 2012 034 437
- US-A1- 2014 130 969
- US-A1- 2014 356 988
- US-A1- 2015 231 858
- US-A1- 2015 284 603

## Beschreibung

Die Erfindungsanmeldung beschreibt ein Verfahren und eine Vorrichtung zum Bonden zweier Substrate.

Besonders wegen der im Produktionsprozess vorgesehenen Rückdünnung des Produktwafers ist eine Stabilisierung des Produktwafers durch den Trägerwafer erforderlich. Nach dem Rückdünnen erreichen die Produktwafer Dicken unter 100 µm, meist unter 50 µm, heute bereits um die 20 µm, in naher Zukunft wahrscheinlich zwischen 1 µm und 20 µm. Wegen der Stabilisierung durch den Trägerwafer können die Wafer extrem gedünnt werden und es können, nach dem Rückdünnen, weitere Bearbeitungsschritte mittels standardisierter Prozesse durchgeführt werden.

In der Halbleiterindustrie werden Produktwafer immer häufiger mit Trägerwafern temporär verklebt. Der Kleber, das sogenannte Bondingadhäsiv, wird dabei auf dem Produktwafer und/oder dem Trägerwafer, in Form einer Schicht mit möglichst homogener Schichtdicke, aufgebracht. Nach dem Beschichtungsvorgang müssen beide Wafer allerdings mit hohen Kräften aneinander gedrückt werden. Dieser Vorgang ist unter dem Begriff Bonden bekannt.

Eine weit verbreitete Methode zur Befestigung eines Wafers an einem Glas-Träger besteht darin, den Glasträger mit dem Substrat großflächig zu verkleben. Der verwendete Kleber hat dabei die Eigenschaft, dass er bei Überschreiten einer gewissen Temperatur seine Klebeeigenschaften verliert. Zur Trennung des Wafers und des Glasträgers wird daher durch den Glasträger Energie z.B. thermisch oder mittels eines Lasers eingetragen, durch die der Kleber seine Adhäsionseigenschaften verliert. Der Verlust der Adhäsionseigenschaften geht meistens auch mit einer Erniedrigung der Viskosität einher. Daraufhin lassen sich Substrat und Glasträger voneinander trennen.

Wird beim temporären Bonden als Bondingadhäsiv ein Thermoplast mit niedriger Glasübergangstemperatur T_{g} verwendet, kann es bei diversen Rückseitenprozessen durch hohe Temperatur und/oder Stress des Produktwafers zu Delaminationen am Waferrand kommen. Polyimide mit niedrigem T_{g} (z.B. ca. 40°C) sind temperaturstabil, aber bei hohen Temperaturen ist die Viskosität so gering, dass das Bondingadhäsiv eine sehr geringe Haltekraft hat bzw. es aus dem Interface rausläuft.

Thermoplaste mit hoher T_{g} wie z.B. das Polyimid HD-3007 haben den Nachteil, dass diese sehr schwer zu reinigen sind und dass starke Lösungsmittel u.a. die Passivierung des Produktwafers angreifen können.

Werden quervernetzende Materialien als Bondingadhäsiv verwendet, sind diese oft sehr schwer zu Debonden, speziell wenn hohe Strukturen oder ungünstige Oberflächenmaterialien am Produktwafer vorhanden sind. Hier ist das Debonden bzw. die Reinigung aufwändig und oftmals werden starke Chemikalien benötigt.

Nachteilig bei bekannten Verfahren ist es insbesondere, dass der Kleber bereits von den während der Rückseitenbearbeitungsprozesse auftretenden Temperaturen zerstört wird, wodurch sich der Wafer bereits während dieser Prozesse von seinem Träger löst. Hierbei kann es durch das frühzeitige Lösen des Klebers zur Zerstörung des Substrats i.e. des Produktwafers kommen.

Andere bekannte Verfahren arbeiten mit Folien, die mit einer Klebstoffschicht versehen sind. Auch dieser Klebstoff verliert seine Klebeeigenschaften bei Überschreiten einer bestimmten Temperatur. Ebenso wie bei den zuvor beschriebenen Verfahren kann es bereits bei Rückseitenbearbeitungsprozessen durch die auftretenden hohen Temperaturen zu einem Lösen der Verbindung zwischen Trägersubstrat und Produktsubstrat kommen.

Im Dokument US2015/231858 wird System und ein Verfahren für ein ablösbares Substrat von einem Träger beschrieben.

Um ein verbessertes Debonding zu erreichen, werden oft mehrere Schichten zwischen Produktsubstrat und Trägersubstrat hergestellt. In WO2010/121068A2 werden z.B. eine mit UV Licht aushärtbare adhäsive Schicht und eine mit Laserlicht erweichbare Trennschicht kombiniert. Durch Laserbestrahlung verändern sich die chemisch-physikalischen Eigenschaften der Trennschicht. Das Debonden von Produktsubstrat und Trägersubstrat erfolgt über die Trennschicht. Mehrschichten-Systeme sind aber in der Herstellung vergleichsweise aufwendig. Die Aufgabe der vorliegenden Erfindung ist es daher, eine Vorrichtung und ein Verfahren anzugeben, um einerseits eine, mit geringstmöglichem Aufwand hergestellte, hohe Bondkraft zwischen den Substraten für alle notwendigen Prozessschritte zu bewirken, anderseits nach Prozessierung des Substratverbunds eine zerstörungsfreie Trennung des dünnen Produktsubstrats vom Substratverbund zu ermöglichen. Zusätzlich sollen die für diesen Vorgang nötigen Verfahrensschritte kostengünstig und für verschiedensten Substrate möglich sein. Diese Aufgabe wird mit dem Gegenstand der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Die Erfindung betrifft ein Verfahren zum temporären Bonden eines Produktsubstrats mit einem Trägersubstrat, aufweisend den folgenden Ablauf:
a) Aufbringen eines Bondingadhäsivs auf das Produktsubstrat und/oder das Trägersubstrat zur Bildung einer Bondingadhäsivschicht,
b) Verbinden des Trägersubstrats mit dem Produktsubstrat über die Bondingadhäsivschicht,
c) Aushärten lediglich eines Teilbereichs der Bondingadhäsivschicht, wobei ein Restbereich der Bondingadhäsivschicht nicht oder zumindest nicht wesentlich ausgehärtet wird.

Die Erfindung betrifft weiterhin eine Vorrichtung zum temporären Bonden eines Produktsubstrats mit einem Trägersubstrat, aufweisend:
a) Aufbringmittel zum Aufbringen eines Bondingadhäsivs auf das Produktsubstrat und/oder das Trägersubstrat zur Bildung einer Bondingadhäsivschicht,
b) Verbindungsmittel zum Verbinden des Trägersubstrats mit dem Produktsubstrat über die Bondingadhäsivschicht,
c) eine Aushärteeinrichtung zum Aushärten lediglich eines Teilbereichs der Bondingadhäsivschicht, wobei ein Restbereich der Bondingadhäsivschicht nicht oder zumindest nicht wesentlich aushärtbar ist.

Das erfindungsgemäße Verfahren bzw. die erfindungsgemäße Vorrichtung hat insbesondere folgende Vorteile:
1. Es besteht eine Schutzschicht zwischen Produkt- und Trägersubstrat,
2. Es ist eine bereichsweise Kontrolle der Aushärtung der Bondingadhäsivschicht möglich.
3. Es ist keine zusätzliche Anti-Adhäsive Beschichtung notwendig. Die Klebekraft braucht nicht durch eine haftreduzierende Schicht reduziert zu werden. Dadurch entstehen weniger Prozess-Schritte, bzw. das Produktsubstrat und/oder das Trägersubstrat müssen nicht vorbehandelt werden.

Als Bondingadhäsivschicht kommt ein Kleber, beispielsweise ein lösbarer Kleber, insbesondere ein Thermoplast, in Frage.

Die Aushärtung kann durch elektromagnetische Strahlung, durch Wärme, durch Strom, durch magnetische Felder und/oder andere Verfahren durchgeführt werden.

Bevorzugt wird das Bondingadhäsiv vollflächig auf das Produktsubstrat und/oder das Trägersubstrat aufgebracht. Hierdurch wird der Herstellungsprozess stark vereinfacht, wodurch der Durchsatz erhöht werden kann. Außerdem hat die Bondingadhäsivschicht die Aufgabe einer Füllschicht zum Schutz der Strukturen und zur leichteren Ablösung von Trägersubstrat und Produktsubstrat.

Alternativ wird das Bondingadhäsiv bevorzugt teilflächig auf das Produktsubstrat und/oder das Trägersubstrat aufgebracht, insbesondere kreisringförmig am äußeren Rand des Produktsubstrats und/oder des Trägersubstrats. Hierdurch kann vorteilhaft das Ablösen vereinfacht werden.

Wird die Bondingadhäsivschicht teilflächig aufgebracht, bleibt insbesondere ein innerer kreisrunder Bereich unbeschichtet. Das Lösen (Debonden) findet insbesondere in einem kreisringförmigen Bereich zwischen Trägersubstrat und Produktwafer statt. Bereiche, die ausgehärtet werden sollen, können von einer Maske vorgegeben werden. Dabei wird insbesondere nur der belichtete äußere Bereich der Bondingadhäsiv vernetzt. Der innere Bereich bleibt dann unbelichtet und dadurch findet in diesem Bereich weitgehend keine Polymerisation statt. Die Bondschicht besteht insbesondere aus zwei Bereichen, die unterschiedlich vernetzt sind, wobei der polymerisierte äußere kreisringförmige Bereich zum temporären Bonden dient.

Bevorzugt wird das Bondingadhäsiv auf Strukturen des Produktsubstrats aufgebracht. Dadurch kann vorteilhaft ein Schutz der Strukturen erreicht werden.

Bevorzugt erfolgt die Aushärtung des Teilbereichs mittels Bestrahlung, insbesondere UV-Bestrahlung, wobei die Aushärteeinrichtung eine, insbesondere einzelne, Strahlungsquelle und/oder ein Lichtquellen-Array umfassen kann. Insbesondere wird eine Maske zwischen einer Strahlungsquelle und den Substraten zur Abschattung des Restbereichs angeordnet. Die Maske weist insbesondere einen für die Strahlung der Strahlungsquelle durchlässigen Bereich und einen undurchlässigen Bereich auf. Alternativ erfolgt die Aushärtung des Teilbereichs durch Bestrahlung mittels eines Lichtquellen-Arrays mit nebeneinanderliegenden Lichtquellen, insbesondere UV-Lichtquellen, wobei die Lichtquellen insbesondere einzeln gesteuert werden können.

Bevorzugt wird lediglich ein äußerster Randbereich der Bondingadhäsivschicht ausgehärtet. Dieses erleichtert die Ablösung der Substrate voneinander.

Bevorzugt wird ein innerer Restbereich der Bondingadhäsivschicht nicht oder zumindest nicht wesentlich ausgehärtet. Hier können sich die Strukturen des Produktsubstrats befinden, sodass ein verbesserter Schutz der Strukturen erreicht werden kann.

Mindestens eines der beiden, insbesondere das Trägersubstrat, kann transparent für elektromagnetische Strahlung des Wellenlängenbereichs, in dem es zu einer Vernetzung des Bondingadhäsivs kommt, sein.

Erfindungsgemäß wird nur jener Teilbereich behandelt, in dem das Bondingadhäsiv aushärten soll. Das wird vorzugsweise die periphere Region sein. Der restliche, insbesondere zentrische Teil, wird nicht behandelt und vernetzt daher nicht oder nur geringfügig. Hierdurch ist es möglich, eine homogene, insbesondere vollflächige, bevorzugt einzelne, Bondschicht zu verwenden, die insbesondere am Rand ihre Klebeeigenschaften durch Aushärtung zeigt und die insbesondere im inneren Bereich die Aufgabe einer Füllschicht hat, insbesondere zum Schutz der Strukturen und zur leichteren Ablösung von Trägersubstrat und Produktsubstrat.

Es können vorteilhaft auch Materialien mit hoher Glasübergangstemperatur (T_{g}) verwendet werden, da das Material bevorzugt nur am Rand und erst beim Quervernetzen fest wird. Das Bonden und Debonden ist bei nahezu Raumtemperatur möglich.

Unter Substraten werden in der Halbleiterindustrie verwendete Produktsubstrate oder Trägersubstrate verstanden. Bei den Substraten handelt es sich mit Vorzug um Wafer oder Produktwafer. Die Substrate können jede beliebige Form besitzen, sind aber bevorzugt kreisrund. Der Durchmesser der Substrate ist insbesondere industriell genormt. Für Wafer sind die industrieüblichen Durchmesser, 1 Zoll, 2 Zoll, 3 Zoll, 4 Zoll, 5 Zoll, 6 Zoll, 8 Zoll, 12 Zoll und 18 Zoll. Die erfindungsgemäße Ausführungsform kann aber grundsätzlich jedes Substrat, unabhängig von dessen Durchmesser handhaben. Die Produktsubstrate können auch beidseitig strukturierte bzw. prozessierte Produktsubstrate sein.

Im Idealfall besitzt eine Schicht für den erfindungsgemäßen Bondvorgang eine homogene Dicke. Homogene Dicke bedeutet in dem Zusammenhang, dass die Dicke der Bondschicht an jeder Position gleich ist bzw. innerhalb einer akzeptablen Toleranz liegt.

Als Kleber bzw. Bondingadhäsiv finden sowohl Thermoplaste mit niedriger Glasübergangstemperatur (T_{g}) und Thermoplaste mit hoher Glasübergangstemperatur, als auch quervernetze Polymere Anwendung. Die Glasübergangstemperatur ist der Temperaturbereich, in dem ein Kunststoff der größten Änderung der Verformungsfähigkeit unterliegt. Faktoren wie z.B. Molmasse, Vernetzungsgrad, Endgruppen, Weichmacher, Kristallinität und intermolekulare Kräfte haben einen Einfluss auf die Glasübergangstemperatur.

Kunststoffe können je nach Eigenschaften in vier Hauptgruppen eingeteilt werden: Elastomere, Thermoplastische Elastomere, Thermoplaste und Duroplaste. Elastomere (schwach vernetzt), Thermoplastische Elastomere (vernetzt) und Duroplaste (stark vernetzt) bestehen aus quervernetzenden Kettenmolekülen. Thermoplaste hingegen sind Kunststoffe, deren Makromoleküle aus linearen oder verzweigten Ketten bestehen und nur durch zwischenmolekulare Kräfte zusammengehalten werden. Unter Wärmeeinwirkung werden die zwischenmolekularen Kräfte schwächer und dadurch werden die Thermoplaste verformbar und verarbeitbar. Ein Temporärkleber ist meistens ein Thermoplast, der oberhalb der Glasübergangstemperatur erweicht. Substrate, die mit Hilfe eines Thermoplasts verklebt wurden, können meistens durch ein Erhitzen des Thermoplasts über die Glasübergangstemperatur wieder voneinander getrennt werden.

Zu den Bondingadhäsiven gehören u.a. Epoxidharze (thermische und/oder UV-Vernetzung), Photoresist-Materialien, Fluoropolymere, Silsesquioxane, Benzocyclobutene, Polymethylmethacrylate, Polydimethylsiloxane, Polyaryleneether, Polyetheretherketone, flüssigkristalline Polymere und thermoplastische Copolymere wie z.B. Polyvinylidenchlorid.

Die temporäre Fixierung ist einfach, schnell durchführbar, kostengünstig, effizient, reversibel, sowie physikalisch und chemisch stabil. Am häufigsten werden die Trägerwafer mit einem Bondingadhäsiv belackt und in einem Bondverfahren zum Produktwafer gebondet. Die Klebeschicht kann über die gesamte Fläche des Trägerwafers und/oder des Produktwafers aufgebracht werden. Der so erzeugte temporäre Bond widersteht hohen Temperaturen und Kräften. Weiters werden bei Bedarf weitere Bearbeitungsschritte auf der zweiten Seite durchgeführt, beispielsweise das Herstellen von Bumps und/oder Bumpgruppen und/oder anderen Verbindungsschichten und/oder elektrische Leiterbahnen und/oder das Aufbringen von Chips. Denkbar wäre auch die Bearbeitungsseite des Produktsubstrats zu wechseln indem ein zweiter Trägerwafer temporär auf die freie Seite gebondet wird und anschließend der erste Trägerwafer entfernt wird.

Die Aushärtung der Klebeschicht erfolgt je nach Material bevorzugt durch elektromagnetische Strahlung, vorzugsweise durch UV-Licht oder IR-Licht. Die elektromagnetische Strahlung besitzt eine Wellenlänge im Bereich zwischen 10nm und 2000nm, mit Vorzug zwischen 10nm und 1500nm, mit größerem Vorzug zwischen 10nm und 1000nm, mit allergrößtem Vorzug zwischen 10nm und 500nm, mit allergrößtem Vorzug zwischen 10nm und 400nm.

Denkbar sind auch thermische Aushärtungen. Die thermische Aushärtung erfolgt zwischen 0°C und 500°C, vorzugsweise zwischen 0°C und 400°C, noch bevorzugter zwischen 0°C und 300°C, am bevorzugtesten zwischen 0°C und 200°C.

Allgemeiner kann die Aushärtung durch elektromagnetische Strahlung, durch Wärme, durch Strom, durch magnetische Felder oder andere Verfahren durchgeführt werden. Der Aushärtung liegt erfindungsgemäß bevorzugt eine Polymerisation des Grundmaterials zu Grunde. Dabei wird die Polymerisation durch einen sogenannten Initiator gestartet. Wird elektromagnetische Strahlung für die Aushärtung verwendet, ist mindestens eines der beiden Substrate, insbesondere der Trägerwafer, transparent für elektromagnetische Strahlung des Wellenlängenbereichs, in dem es zu einer Vernetzung des Bondingadhäsivs kommt. Insbesondere ist der Trägerwafer daher ein Glas- oder Saphirwafer.

Die Klebeschicht hat bis zu einem bestimmten Temperaturbereich ausreichende Hafteigenschaften (nicht lösbare Verbindung), um die beiden Substrate ausreichend zu fixieren. Die Hafteigenschaften werden über die physikalische Größe der Adhäsion beschrieben. Die Adhäsion wird vorzugsweise über die Energie pro Flächeneinheit definiert, die notwendig ist, um zwei miteinander verbundene Oberflächen voneinander zu trennen. Die Energie wird dabei in J/m² angegeben. Ein typischer, empirisch gemessener Mittelwert der Energie pro Flächeneinheit, zwischen reinem Silizium und einem Polymer, liegt bei ca. 1.2 J/m². Entsprechende Werte können je nach Beschichtungsmaterial, Substratmaterial und Verunreinigung, in diesem Fall einem Polymer, schwanken. In Zukunft ist auch mit weit effizienteren Beschichtungsmaterialen zu rechnen. Die Energie pro Einheitsfläche ist dabei größer als 0.00001 J/m², mit Vorzug größer als 0.0001 J/m², mit größerem Vorzug größer als 0.001 J/m², mit größtem Vorzug größer als 0.01 J/m², mit allergrößtem Vorzug größer als 0.1 J/m², am bevorzugtesten größer als 1 J/m².

Zum Trennen werden z.B. die beiden Substrate über diesen Temperaturbereich erhitzt und dadurch verliert der Kleber die Klebeeigenschaften und durch Einbringen von horizontaler und/oder vertikaler Kraft werden diese beiden Wafer, Trägerwafer und Produktwafer, getrennt. Bei hohen Temperaturen kommt es allgemein zu einer thermischen Zersetzung der Polymere. Werden Thermoplaste eingesetzt, muss nur bis oberhalb der Glasübergangstemperatur erhitzt werden.

Zusätzlich können die Randzonen entsprechend physikalisch und/oder chemisch und/oder thermo-mechanisch und/oder mechanisch behandelt werden, damit der Temporärbond seine Adhäsion verliert.

Die Klebeschicht kann auch nur am Rand des Produktwafers und/oder des Trägerwafers aufgebracht werden. Der innere Bereich beinhaltet nicht notwendigerweise eine klebende Schicht. Die Schicht des inneren Bereichs kann beliebige Eigenschaften haben, wird aber meist als Stützmittel in die Zwischenräume der einzelnen Strukturen, z.B. Bumps, eingebracht.

Der Trennvorgang ist ähnlich dem Trennvorgang eines vollflächigen Bonds, allerdings müssen nur die Randzonen entsprechend physikalisch und/oder chemisch behandelt werden, damit der Temporärbond seine Adhäsion verliert. Damit gehen geringere Temperaturen, geringere Prozesszeiten, geringerer Materialverbrauch an Chemikalien einher.

Es existieren noch unzählige weitere Verfahren, einen temporaren Bond wieder aufzulösen, beispielsweise durch spezielle Laser und Verwendung einer zusätzlichen Trennschicht, oder durch Trägerwafer mit Löchern geringen Durchmessers, durch welche vollflächig ein entsprechendes Losungsmittel in den Bond eingebracht wird. Weiteres kann eine Zerstörung oder Spaltung der Randzone durch Laser, Plasmaätzen, Wasser- oder Lösungsmittelstrahl durchgeführt werden.

Das Bondingadhäsiv kann insbesondere durch ein Glassubstrat belichtet werden. Um eine gleichmäßige Bestrahlung zu verhindern, werden eine Maske und/oder ein beschichteter Glasträger benötigt. Dafür wird z.B. ein Glassubstrat mit einem Film beschichtet, der durchlässige und lichtundurchlässige Bereiche aufweist. Die Beschichtung kann permanent oder temporär sein. Ist die Beschichtung temporär, kann der Film vom Glassubstrat wieder entfernt werden. Damit verbleibt der Glasträger im Trägersubstrat-Produktsubstrat-Verbund und kann bei Bedarf in weiteren Prozessschritten genutzt werden. Alternativ wird zusätzlich zum Trägersubstrat eine Maske verwendet. Die Maske kann erfindungsgemäß u.a. auch aus einem Glasträger und darauf aufgebrachte undurchlässige Bereiche bestehen. Das lichtempfindliche Bondadhäsiv wird mittels UV-Licht belichtet, wobei die Bereiche, die ausgehärtet werden sollen, von der Maske vorgegeben werden. Die Maske dient dazu, nicht zu belichtende Bereiche abzuschatten.

Als Aufnahmeeinrichtung eignet sich besonders ein Chuck, insbesondere ein Spinner-Chuck zur Aufnahme des Trägersubstrat-Produktsubstrat-Verbundes, insbesondere mittels Unterdruck, beispielsweise Saugbahnen, Bohrungen und/oder Saugnäpfen. Alternativ ist eine elektrostatische Aufnahme und/oder eine mechanische Aufnahme, beispielsweise durch seitliche Klammern, denkbar.

In einer weiteren vorteilhaften Ausführungsform der Erfindung ist vorgesehen, dass anstatt einer Maske eine mehrteilige Blende verwendet wird, um selektiv ausgewählte Bereiche der Stapeloberfläche, speziell den Rand, zu belichten.

In einer alternativen Ausführungsform der Erfindung ist vorgesehen, dass die Lichtquelle für die Aushärtung der Klebeschicht viele nebeneinanderliegende UV-Lichtquellen beinhaltet, die insbesondere einzeln gesteuert werden können. Durch die Verwendung eines solchen Arrays von UV-Lichtquellen, die insbesondere einzeln gesteuert werden können, kann das UV-Licht selektiv ausgewählte Bereiche der Stapeloberfläche, speziell den Rand, belichten. Dadurch ist in dieser Ausführungsform keine Maske notwendig.

Das Debonden nach der Prozessierung des Produktsubstrats erfolgt so, dass zuerst das ausgehärtete, sich am Rand befindliche, vollständig quervernetzte Bondingadhesiv gelöst wird, insbesondere chemisch und/oder mechanisch. Die Bestrahlungsdosis beim Aushärten muss so gewählt werden, dass sich das teilweise quervernetzte Areal durch Slide-off bzw. Lift-off (mit oder ohne Temperatur) wieder trennen lässt.

In einer vorteilhaften Ausführungsform der Erfindung ist vorgesehen, dass das Verbindungslösemittel Fluidmittel, insbesondere ein die Verbindungsschicht selektiv auflösendes Lösungsmittel, zur Lösung der Verbindungsschicht umfasst. Die chemische Auflösung der Verbindungsschicht ist für die Substrate besonders schonend und bei entsprechender Materialwahl kann die Auflösung auch sehr schnell erfolgen, insbesondere wenn nur Randbereiche der Substrate mit einer Verbindungsschicht versehen sind, so dass das Lösungsmittel von der Seite her schnell wirken kann. Auf diese Weise kann auf Perforierungen im Trägersubstrat und/oder Produktsubstrat verzichtet werden.

In Weiterbildung der Erfindung ist vorgesehen, dass zum Trennen von Produkt- und Trägersubstrat der, insbesondere ringförmige, vernetzte Teil der Kleberschicht auf eine vorgegebene Temperatur erhitzt wird. Bei dieser Temperatur verliert der Kleber, z.B. ein Thermoplast, seine Klebeeigenschaft, so dass ein Lösen von Produktsubstrat und Trägersubstrat möglich ist. Es sollte darauf geachtet werden, dass die Erwärmung ausschließlich in dem Bereich der, insbesondere ringförmigen, vernetzten (insbesondere äußeren) Kleberschicht erfolgt, um die Strukturierungen des Produktsubstrats nicht zu beschädigen. Zur Erhitzung der Kleberschicht eignet sich insbesondere ein Heizelement mit ringförmigem Heizabschnitt. Alternativ kann eine lokale Erwärmung der Bondschicht durch Laserlicht erfolgen, was insbesondere bei einer ringförmigen Bondschicht von Vorteil sein kann.

In einer alternativen Ausführungsform der Erfindung ist vorgesehen, dass das Verbindungslösemittel mechanische Trennmittel, insbesondere eine Klinge zum Durchschneiden der Verbindungsschicht, zur Lösung der Verbindungsschicht umfasst. Hierdurch ist eine besonders schnelle Trennung des Produktsubstrats vom Träger möglich. Denkbar ist auch eine Kombination aus mechanischen Trennmitteln und Fluidmitteln. Die Vorrichtung zur Trennung von Produktsubstrat und Trägersubstrat wird in der Patentschrift EP2402981B1 beschrieben. In EP 2402981B1 werden eine Vorrichtung und ein Verfahren zum Ablösen eines Wafers von einem Träger beschrieben. Die Trennung bzw. Trennungsvorrichtung erfolgt gemäß der Patentschrift EP2402981B1 und wird nicht näher beschrieben.

Im Idealfall sollten dann Trägersubstrat und Produktsubstrat voneinander trennbar sein, da das Bondingadhäsiv insbesondere im Zentrum nicht vernetzt wurde. Ansonsten muss dennoch ein Slide-off Debond durchgeführt werden. Die Druckschrift DE102009018156A1 beschreibt eine Vorrichtung beziehungsweise ein Verfahren zum Trennen eines Substrats von einem mit dem Substrat durch eine Verbindungsschicht verbundenen Trägersubstrat, bei welchem die Trennung des Substrats durch Parallelverschiebung von Substrat und Trägersubstrat gegeneinander erfolgt (Slide-off). Die Druckschrift WO2013/120648 beschreibt ein Verfahren, bei dem ein Ablösen durch Einbringung einer Zugkraft erfolgt (Liftoff).

Allgemein sind Kombinationen aus chemischen, thermischen, mechanischen und optischen Verfahrensschritten zum Lösen der Bondschicht möglich.

In einer weiteren vorteilhaften Ausführungsform wird als Klebeschicht ein Material verwendet, das bei verschiedenen Wellenlängen den Aggregatzustand verändert. Solche licht-gesteuerte adhäsive Materialien werden z.B. in der Druckschrift US 2015/0159058A1 beschrieben, wo ein flüssigkristallines Polymer eingesetzt wird. In dieser Ausführungsform wird der Licht-gesteuerte Kleber mit Vorteil während der Rotation des Trägersubstrats oder des Produktsubstrats aufgebracht und durch die Rotation des Substrats auf diesen gleichmäßig und homogen verteilt.

Alternativ wird der Licht-gesteuerte Kleber nicht großflächig zwischen Trägersubstrat und Produktsubstrat aufgebraucht, sondern ausschließlich ringförmig im Randbereich zwischen Produktsubstrat und Trägersubstrat aufgebracht. Gebondet wird im flüssigen Kleber-Zustand, indem nach dem Aufbringen mit der richtigen Wellenlänge belichtet wird (mit oder ohne Maske je nach Bedarf). Mit der Wellenlänge λ₁ bzw. dem Wellenlängenbereich Δλ₁ wird der Kleber fest. Nach dem Prozessieren der Rückseite vom Substrat-Stapel wird mit der zweiten Wellenlänge λ₂ bzw. mit dem zweiten Wellenlängenbereich Δλ₂ belichtet, sodass der Kleber wieder flüssig wird und ein Debonden durch Slide-off oder Lift-off möglich ist.

Die Erfindung kann in Kombination mit den etablierten industriellen Belackungsverfahren angewendet werden, wie z.B. Spin-Coating-Verfahren oder Sprühbelackungsverfahren. Wird ein Bondingadhäsiv für eine gezielte, UVgesteuerte, räumliche Aushärtung verwendet, wird der Herstellungsprozess stark vereinfacht, da nur eine Bondschicht vollflächig aufgetragen werden muss. Somit ist das Belacken des Substrats schnell, vollflächig und standardisiert, was auch Durchsatz-Vorteile bringt. Des Weiteren müssen keine Substrat- bzw. Trägersubstratoberflächen vorbehandelt werden, da keine weiteren Beschichtungen (wie z.B. eine Antihaftschicht oder eine Trennschicht) notwendig sind.

Durch die vorliegende Erfindung ist eine mehrmalige Verwendung des Trägersubstrats möglich, ohne dieses durch aufwändige und teure Prozesse reinigen zu müssen. Soweit beim Ablösen noch Reste des Bondingadhäsiv an dem Produktsubstrat oder Trägersubstrat verbleiben, können diese durch einen Reinigungsschritt entfernt werden.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a:: eine Querschnittsansicht eines Produktsubstrats mit Strukturen,
- Figur 1b:: eine Querschnittsansicht des Produktsubstrats nach dem Aufbringen einer Bondingadhäsivschicht,
- Figur 1c :: eine Querschnittsansicht eines Produktsubstrat-Trägersubstrat-Stapels mit einer Belichtungsmaske,
- Figur 1d:: eine weitere Querschnittsansicht des Produktsubstrat-Trägersubstrat-Stapels,
- Figur 1e:: eine weitere Querschnittsansicht des Produktsubstrat-Trägersubstrat-Stapels nach dem temporären Bonden,
- Figur 2a:: eine weitere Querschnittsansicht des Produktsubstrat-Trägersubstrat-Stapels und eine UV-Quelle,
- Figur 2b:: eine weitere Querschnittsansicht des Produktsubstrat-Trägersubstrat-Stapels und einen UV-Lichtquellen-Array,
- Figur 3a:: eine weitere Querschnittsansicht des Produktsubstrat-Trägersubstrat-Stapels mit vollflächig aufgebrachter Bondingadhäsivschicht,
- Figur 3b:: eine weitere Querschnittsansicht des Produktsubstrat-Trägersubstrat-Stapels mit teilflächig aufgebrachter Bondingadhäsivschicht.

In den Figuren sind gleiche Bauteile oder Bauteile mit der gleichen Funktion mit den gleichen Bezugszeichen gekennzeichnet.

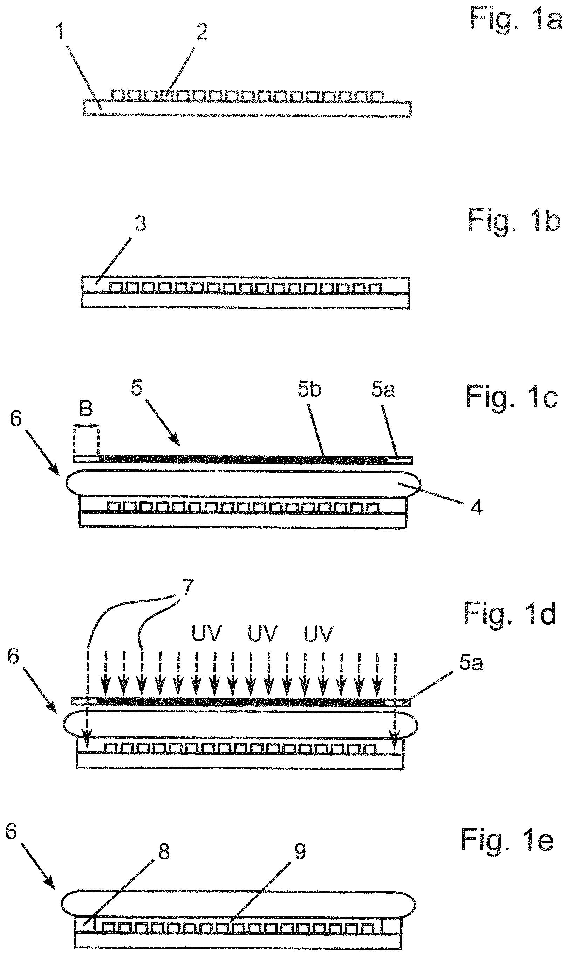

Die Figuren 1a-1e beschreiben einen beispielhaften erfindungsgemäßen Verfahrensablauf zum temporären Verbinden eines mit Strukturen 2 bestückten Produktsubstrats 1 mit einem Trägersubstrat 4. Das Verfahren wird insbesondere in einer nicht dargestellten Bondkammer durchgeführt. Die Strukturen 2 können z.B. Lotkugeln oder Chips sein und bilden eine Topographie (siehe Figur 1a). Denkbar ist auch, dass das Produktsubstrat 1 über keine Topographie verfügt, entweder weil keine Strukturen 2 vorhanden sind oder weil die Strukturen 2 direkt im Produktsubstrat 1 gefertigt wurden.

Gemäß Fig. 1b ist die Bondingadhäsiv-Schicht 3 ganzflächig auf die Strukturen 2 aufgebracht worden, welche in und/oder auf dem Produktsubstrat 1 liegen. Die Schichtdicke der Beschichtung wird an die Topographie angepasst und liegt insbesondere zwischen 1 µm und 15 mm, mit Vorzug zwischen 10 µm und 10 mm, mit größerem Vorzug zwischen 50 µm und 10 mm, mit größtem Vorzug zwischen 100 µm und 5 mm. Eine Substrataufnahmeeinrichtung (nicht dargestellt) ermöglicht das Handling der Substrate mit einer flüssigen Schicht darauf. Die flüssige Schicht ist insbesondere ein flüssiger Thermoplast der sich im sogenannten Interface während des Kontaktierens mit dem Trägerwafer befindet. Die Lösungsmittelkonzentration der flüssigen Schicht liegt insbesondere zwischen 0 und 80%, mit Vorzug zwischen 0 und 65%, mit größerem Vorzug zwischen 0 und 50%. Die Schichtdicke hängt u.a. auch von der Viskosität der Lösung ab. Die Viskosität ist eine physikalische Eigenschaft, die stark temperaturabhängig ist. Diese nimmt im Allgemeinen mit zunehmender Temperatur ab. Die Viskosität liegt bei Raumtemperatur zwischen 10⁶ Pa^{∗}s und 1 mPa^{∗}s, vorzugsweise zwischen 10⁵ Pa^{∗}s und 1 Pa^{∗}s, noch bevorzugter zwischen 10⁴ mPa^{∗}s und 1 Pa^{∗}s, am bevorzugtesten zwischen 10³ Pa^{∗}s und 1 Pa^{∗}s.

Nach dem Beschichten des Produktwafers 1 mit dem Bondingadhäsiv 3 gemäß Figur 1b wird der Produktwafer in einem temporären Bondverfahren durch Ausrichten, Kontaktieren und Bonden, zum Trägersubstrat 4 gebondet. Dem Fachmann auf dem Gebiet sind die temporären Bondingtechnologien bekannt.

Gemäß den Figuren 1c und 1d wird die Bondingadhäsiv-Schicht 3 durch eine Maske 5 hindurch mittels Licht, insbesondere UV-Licht, belichtet. Die Bereiche, die ausgehärtet werden sollen, werden von der Maske 5 vorgegeben. Die Maske 5 kann jede Form haben, mit Vorzug rund, rechteckig oder quadratisch, mit größerem Vorzug im Trägersubstrat-Format, mit allergrößtem Vorzug den, in der Lithographie genutzten Standardformaten folgend. Der Durchmesser der Maske 5 stimmt vorzugsweise weitgehend mit dem Durchmesser des Trägersubstrats 4 überein. Die Maske 5 hat dann annähernd die Größe des Trägersubstrats und besteht aus durchlässigen Bereichen 5a und undurchlässigen 5b Bereichen für den ausgewählten Lichtwellenlängenbereich. Alternativ kann ein beschichteter Glasträger als Maske verwendet werden. Die in Figuren 1c und 1d gezeigte Maske 5 wurde so hergestellt, dass eine innere Kreisfläche 5b der Maske 5 lichtundurchlässig ist und eine äußere Kreisringfläche 5a der Maske 5 lichtdurchlässig ist. Die äußere Kreisringfläche 5a weist eine Ringbreite B auf. Die Belichtung der Bondingadhäsiv-Schicht 3 kann von der Seite des Trägersubstrats 4 und/oder der Seite des Produktwafers 1 erfolgen. Entscheidend ist vor allem die Transparenz des jeweils durchstrahlten Substrats/Wafers für die jeweils verwendete elektromagnetische Strahlung.

Alternativ werden andere Materialien als Kleber verwendet, die je nach Eigenschaften als Positiv- oder Negativkleber eingesetzt werden und eine entsprechende angepasste Belichtungsmaske benötigen. Ein Negativkleber polymerisiert durch Belichtung während ein Positivkleber durch Belichtung wieder löslich für entsprechende Lösungsmittel wird bzw. seine Klebeeigenschaften verliert.

Figur 1d zeigt, dass der Stapel 6 mit UV-Licht 7 über die Maske 5 belichtet wird. Durch die Maske 5 ist nur die äußere Kreisfläche 5a für das UV-Licht durchlässig. Dabei wird gemäß Figur 1e nur der belichtete äußere Bereich 8 der Schicht 3 vernetzt. Der innere Bereich 9 bleibt unbelichtet und dadurch findet in diesem Bereich keine Polymerisation statt. Die Bondschicht 3 besteht in dieser Ausführungsform gemäß Figur 1e aus zwei Bereichen 8 und 9, die unterschiedlich vernetzt sind, wobei der polymerisierte äußere kreisringförmige Bereich 8 zum temporären Bonden und der nicht- oder nur geringfügig polymerisierte innere kreisrunde Bereich 9 zum Einbetten der Strukturen 2 dient. Die Ringbreite B des äußeren Bereiches 8 liegt zwischen 0 und 30 mm, bevorzugt zwischen 0,1 und 20 mm, noch bevorzugter zwischen 0,25 und 10 mm, am bevorzugtesten zwischen 0,5 und 5 mm.

Die erfindungsgemäße Methode verlagert also die hochadhäsiven und niedrigadhäsiven Zonen, die im Stand der Technik am Trägerwafer durch mehrere Prozessschritte hergestellt werden müssen, in die Bondschicht. Es ist dadurch keine Oberflächenbehandlung der Substrate, z.B. keine Anti-Adhäsive Beschichtung, notwendig. Das Lösen (Debonden) findet im kreisringförmigen Bereich 8 zwischen Trägersubstrat und Produktwafer statt.

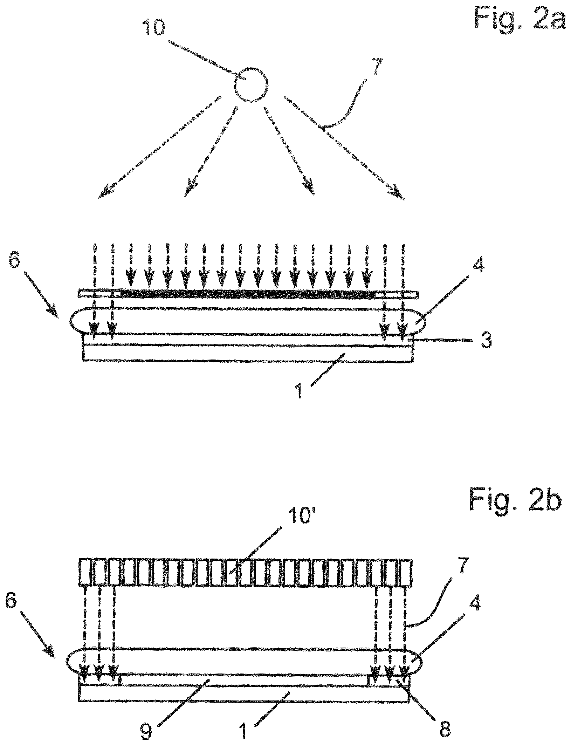

Gemäß den beiden beispielhaften Ausführungsformen in den Figuren 2a und 2b wird mindestens eine UV-Lichtquelle 10, 10' eingesetzt. Die in der Regel ungerichtete Abstrahlung der UV-Lichtquelle 10 (siehe Figur 2a) wird z.B. durch Reflektoren und/oder durch ein Linsen-System (nicht dargestellt) auf den Stapel 6 gerichtet. Dabei soll eine möglichst homogene Verteilung der Strahlung auf den Stapel 6 erreicht werden. Das verwendete UV-Licht 7 ist wahlweise breitbandiges Licht oder speziell abgestimmt auf den verwendeten Photoinitiator in der Bondingadhäsivschicht 3. Der Wellenlängenbereich des UV-aushärtbaren Materials 3 liegt insbesondere zwischen 50 nm und 1000 nm, vorzugsweise zwischen 150 nm und 500 nm, mit größerem Vorzug zwischen 200 nm und 450 nm. Durch die Maske 5 werden die Bereiche 8 definiert, die belichtet werden sollen.

In einer alternativen Ausführungsform gemäß Figur 2b wird ein Array von UV-Lichtquellen 10' verwendet, wobei die UV-Lichtquellen 10' bevorzugt einzeln gesteuert werden. Das Lichtquellen-Array 10' kann direkt zum Substrat-Trägersubstrat-Stapel 6 hingeführt werden oder es können Lichtleiter eingesetzt werden, wodurch sich die Lichtquellen 10' außerhalb der Bondingkammer befinden können. Das Bondingadhäsiv 3 wird in dieser Ausführungsform vollflächig auf den Träger 4 und/oder Produktwafer 1 aufgebracht. Trägerwafer und Produktwafer werden danach gebondet. Einer der beiden, insbesondere der Trägerwafer 4, ist transparent für elektromagnetische Strahlung des Wellenlängenbereichs, in dem es zu einer Vernetzung des Bondingadhäsivs 3 kommt. Durch selektive Steuerung der UV-Lichtquellen 10' aus dem Array wird nur jener Teilbereich 8 belichtet, in dem das Bondingadhäsiv 3 aushärten soll. Das ist vorzugsweise die periphere Region 8. Der restliche, insbesondere zentrische Teil 9, wird nicht bestrahlt und vernetzt daher nicht. Wird als Bondingadhäsiv 3 ein Material verwendet, das bei verschiedenen Wellenlängen den Aggregatzustand verändert, wird nach dem Prozessieren mit einer zweiten Wellenlänge λ₂ bzw. mit einem zweiten Wellenlängenbereich Δλ₂ belichtet, sodass das Bondingadhäsiv wieder flüssig wird und ein Debonden möglich ist.

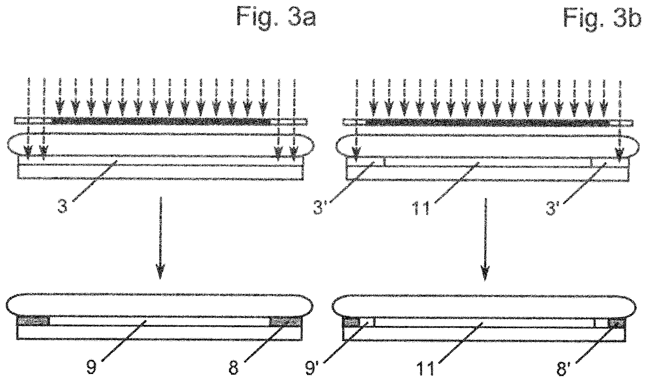

Gemäß den Figuren 3a und 3b kann die Bondingadhäsivschicht vollflächig 3 oder teilflächig 3' aufgebracht werden. Wird die Bondingadhäsivschicht teilflächig aufgebracht, bleibt der innere kreisrunde Bereich 11 unbeschichtet. Das Lösen (Debonden) findet in Figur 3a im kreisringförmigen Bereich 8 zwischen Trägersubstrat und Produktwafer statt. Analog findet in Figur 3b das Lösen (Debonden) im kreisringförmigen Bereich 8' zwischen Trägersubstrat und Produktwafer statt. Auch hier werden die Bereiche, die ausgehärtet werden sollen, von einer Maske 5 vorgegeben. Dabei wird gemäß Figur 3b nur der belichtete äußere Bereich 8' der Schicht 3' vernetzt. Der innere Bereich 9' bleibt unbelichtet und dadurch findet in diesem Bereich weitgehend keine Polymerisation statt. Die Bondschicht 3' besteht in dieser Ausführungsform gemäß Figur 3b aus zwei Bereichen 8' und 9', die unterschiedlich vernetzt sind, wobei der polymerisierte äußere kreisringförmige Bereich 8' zum temporären Bonden dient.

Den vorbeschriebenen Ausführungsformen ist gemein, dass die Bondschicht 3 nach dem Aushärten aus einer heterogenen Schicht besteht. Diese Bondschicht 3 soll speziell am Rand aushärten. Der restliche, insbesondere zentrische Teil, wird nicht bestrahlt und vernetzt daher nicht oder nur geringfügig. Substrat-Oberflächenbehandlungsschritte sowie zusätzliche Schichten wie Trennschichten fallen weg. Das führt zu einem schnelleren sowie vereinfachten temporären Bondverfahren. Die temporäre Fixierung ist somit einfach, schnell durchführbar, kostengünstig, effizient, reversibel, sowie physikalisch und chemisch stabil. Durch die Fixierung im Randbereich ist die Verbindung zwischen dem Trägerwafer und dem Produktwafer nach den Produktionsschritten einfach und schnell chemisch und/oder mechanisch lösbar.

Für verminderte Defekte kann das Aufbringen des Bondadhäsivs 3 sowie das temporäre Bonden im Vakuum und/oder unter Inertgasatmosphäre durchgeführt werden. Das Durchführen der Arbeitsschritte unter Inertgasatmosphäre kann Vorteile bringen wie bessere chemische Beständigkeit, weniger Defekte und schnellere UV-Härtung. Weiters können unter Inertgasatmosphäre entstehende Gaseinschlüsse weitgehend vermieden oder ausgeschlossen werden. Alternativ kann der gesamte Arbeitsraum mit einem Inertgas beaufschlagt werden und/oder über eine Vakuumeinrichtung mit einem Vakuum als definierte Atmosphäre beaufschlagt werden.

### Bezugszeichenliste

- 1: Produktsubstrat
- 2: Struktur
- 3, 3': Bondingadhäsiv
- 4: Trägersubstrat
- 5: Maske
- 5a: durchlässiger Bereich
- 5b: undurchlässiger Bereich
- 6: Stapel
- 7: UV-Licht
- 8, 8': Äußerer Bereich
- 9, 9': Innerer Bereich
- 10, 10': UV-Lichtquelle
- 11: Nicht-beschichteter Bereich
- B: Ringbreite

## Patentansprüche

1. Verfahren zum temporären Bonden eines Produktsubstrats (1) mit einem Trägersubstrat (4), aufweisend den folgenden Ablauf:
a) Aufbringen eines Bondingadhäsivs (3, 3') auf das Produktsubstrat (1) und/oder das Trägersubstrat (4) zur Bildung einer Bondingadhäsivschicht (3, 3'),
b) Verbinden des Trägersubstrats (4) mit dem Produktsubstrat (1) über die Bondingadhäsivschicht (3,3'),
c) nach Schritt b) erfolgt das Aushärten lediglich eines Teilbereichs (8) der Bondingadhäsivschicht (3), wobei ein Restbereich (9,9') der Bondingadhäsivschicht (3) nicht oder zumindest nicht wesentlich ausgehärtet wird.

2. Verfahren nach Anspruch 1, wobei das Bondingadhäsiv (3) vollflächig auf das Produktsubstrat (1) und/oder das Trägersubstrat (4) aufgebracht wird.

3. Verfahren nach einem der vorhergehenden Ansprüche, wobei das Bondingadhäsiv (3') teilflächig auf das Produktsubstrat (1) und/oder das Trägersubstrat (4) aufgebracht wird, insbesondere kreisringförmig am äußeren Rand des Produktsubstrats (1) und/oder des Trägersubstrats (4).

4. Verfahren nach einem der vorhergehenden Ansprüche, wobei das Bondingadhäsiv (3,3') auf Strukturen (2) des Produktsubstrats (1) aufgebracht wird.

5. Verfahren nach einem der vorhergehenden Ansprüche, wobei die Aushärtung des Teilbereichs (8,8') mittels Bestrahlung (7), insbesondere UV-Bestrahlung (7), erfolgt.

6. Verfahren nach einem der vorhergehenden Ansprüche, wobei eine Maske (5) zwischen einer Strahlungsquelle (10) und den Substraten (1, 4) zur Abschattung des Restbereichs (9,9') angeordnet wird.

7. Verfahren nach einem der vorhergehenden Ansprüche, wobei die Aushärtung des Teilbereichs (8,8') durch Bestrahlung mittels eines Lichtquellen-Arrays mit nebeneinanderliegenden Lichtquellen, insbesondere UV-Lichtquellen, erfolgt, wobei die Lichtquellen insbesondere einzeln gesteuert werden können.

8. Verfahren nach einem der vorhergehenden Ansprüche, wobei lediglich ein äußerster Randbereich (8,8') der Bondingadhäsivschicht (3,3') ausgehärtet wird.

9. Verfahren nach einem der vorhergehenden Ansprüche, wobei ein innerer Restbereich (9,9') der Bondingadhäsivschicht (3,3') nicht oder zumindest nicht wesentlich ausgehärtet wird.

10. Vorrichtung zum temporären Bonden eines Produktsubstrats (1) mit einem Trägersubstrat (4), aufweisend:
a) Aufbringmittel zum Aufbringen eines Bondingadhäsivs (3,3') auf das Produktsubstrat (1) und/oder das Trägersubstrat (4) zur Bildung einer Bondingadhäsivschicht (3,3'),
b) Verbindungsmittel zum Verbinden des Trägersubstrats (4) mit dem Produktsubstrat (1) über die Bondingadhäsivschicht (3,3'),
c) eine Aushärteeinrichtung (10, 10') zum Aushärten lediglich eines Teilbereichs (8,8') der Bondingadhäsivschicht (3,3') nach dem Verbinden des Trägersubstrats (4) mit dem Produktsubstrat (1), wobei ein Restbereich (9,9') der Bondingadhäsivschicht (3,3') nicht oder zumindest nicht wesentlich aushärtbar ist.

11. Vorrichtung nach Anspruch 10, wobei die Aushärteeinrichtung (10, 10') eine Strahlungsquelle (10), insbesondere eine UV-Lichtquelle (10), umfasst.

12. Vorrichtung nach einem der vorhergehenden Ansprüche, aufweisend eine Maske (5) zwischen der Strahlungsquelle (10) und den Substraten (1, 4) zur Abschattung des Restbereichs (9,9').

13. Vorrichtung nach einem der vorhergehenden Ansprüche, wobei die Maske (5) einen für die Strahlung der Strahlungsquelle (10) durchlässigen Bereich (5a) und einen undurchlässigen Bereich (5b) aufweist.

14. Vorrichtung nach einem der vorhergehenden Ansprüche, wobei die Aushärteeinrichtung (10, 10') ein Lichtquellen-Array (10') mit nebeneinanderliegenden, insbesondere einzeln steuerbaren, Lichtquellen umfasst.

## Claims

1. A method for temporarily bonding a product substrate (1) to a carrier substrate (4) comprising the following procedure:
a) applying a bonding adhesive (3, 3') to the product substrate (1) and/or the carrier substrate (4) for forming a bonding adhesive layer (3, 3'),
b) connecting the carrier substrate (4) to the product substrate (1) via the bonding adhesive layer (3, 3'),
c) after step b) hardening merely a partial area (8) of the bonding adhesive layer (3), wherein a remaining area (9, 9') of the bonding adhesive layer (3) is not hardened or at least not substantially hardened.

2. The method according to claim 1, wherein the bonding adhesive (3) is applied full-surface onto the product substrate (1) and/or the carrier substrate (4).

3. The method according to claim 1, wherein the bonding adhesive (3') is applied part-surface onto the product substrate (1) and/or the carrier substrate (4), in particular in a circular-ring shaped manner onto the outer rim of the product substrate (1) and/or the carrier substrate (4).

4. The method according to claim 1, wherein the bonding adhesive (3, 3') is applied to structures (2) of the product substrate (1).

5. The method according to claim 1, wherein hardening of the partial area (8, 8') is effected by means of irradiation (7), in particular UV irradiation (7).

6. The method according to claim 1, wherein a mask (5) is arranged between a radiation source (10) and the substrates (1, 4) for shading the remaining area (9, 9').

7. The method according to claim 1, wherein hardening of the partial area (8, 8') is effected by irradiation by means a light source array with adjacently arranged light sources, in particular UV light sources, wherein the light sources can, in particular, be controlled individually.

8. The method according to claim 1, wherein merely an outermost rim area (8, 8') of the bonding adhesive layer (3, 3') is hardened.

9. The method according to claim 1, wherein an inner remaining area (9, 9') of the bonding adhesive layer (3, 3') is not or at least not substantially hardened.

10. A device for temporarily bonding a product substrate (1) to a carrier substrate (4) comprising:
a) application means for applying a bonding adhesive (3, 3') to the product substrate (1) and/or the carrier substrate (4) for forming a bonding adhesive layer (3, 3'),
b) connecting means for connecting the carrier substrate (4) to the product substrate (1) via the bonding adhesive layer (3, 3'),
c) a hardening device (10, 10') for hardening merely a partial area (8, 8') of the bonding adhesive layer (3, 3') after connecting the carrier substrate (4) to the product substrate (1), wherein a remaining area (9, 9') of the bonding adhesive layer (3, 3') cannot be hardened or at least not substantially hardened.

11. The device according to claim 10, wherein the hardening device (10, 10') comprises a radiation source (10), in particular a UV light source (10).

12. The device according to claim 11, comprising a mask (5) between the radiation source (10) and the substrates (1, 4) for shading the remaining area (9, 9').

13. The device according to claim 12, wherein the mask (5) comprises an area (5a) permeable to the radiation of the radiation source (10) and an impermeable area (5b).

14. The device according to claim 10, wherein the hardening device (10, 10') comprises a light source array (10') with adjacently arranged, in particular individually controllable light sources.

## Revendications

1. Procédé pour le collage temporaire d'un substrat de produit (1) avec un substrat porteur (4), présentant le déroulement suivant :
a) application d'un adhésif de collage (3, 3') sur le substrat de produit (1) et/ou le substrat porteur (4) pour former une couche d'adhésif de collage (3, 3'),
b) liaison du substrat porteur (4) avec le substrat de produit (1) par le biais de la couche d'adhésif de collage (3, 3'),
c) après l'étape b) a lieu le durcissement d'une zone partielle (8) seulement de la couche d'adhésif de collage (3), dans lequel une zone restante (9, 9') de la couche d'adhésif de collage (3) n'est pas durcie ou au moins n'est pas essentiellement durcie.

2. Procédé selon la revendication 1, dans lequel l'adhésif de collage (3) est appliqué sur toute la surface sur le substrat de produit (1) et/ou le substrat porteur (4).

3. Procédé selon l'une des revendications précédentes, dans lequel l'adhésif de collage (3') est appliqué partiellement sur le substrat de produit (1) et/ou le substrat porteur (4), en particulier en formant un anneau sur le bord extérieur du substrat de produit (1) et/ou du substrat porteur (4).

4. Procédé selon l'une des revendications précédentes, dans lequel l'adhésif de collage (3, 3') est appliqué sur des structures (2) du substrat de produit (1).

5. Procédé selon l'une des revendications précédentes, dans lequel le durcissement de la zone partielle (8, 8') est effectué par irradiation (7), en particulier par irradiation aux UV (7).

6. Procédé selon l'une des revendications précédentes, dans lequel un masque (5) est agencé entre une source d'irradiation (10) et les substrats (1, 4) pour occulter la zone restante (9, 9').

7. Procédé selon l'une des revendications précédentes, dans lequel le durcissement de la zone partielle (8, 8') est effectué par irradiation au moyen d'une rangée de sources lumineuses avec des sources lumineuses placées les unes à côté des autres, en particulier des sources lumineuses aux UV, dans lequel les sources lumineuses peuvent en particulier être commandées individuellement.

8. Procédé selon l'une des revendications précédentes, dans lequel seule une zone de bordure (8, 8') la plus extérieure de la couche d'adhésif de collage (3, 3') est durcie.

9. Procédé selon l'une des revendications précédentes, dans lequel une zone partielle (9 ; 9') intérieure de la couche d'adhésif de collage (3, 3') n'est pas durcie ou au moins n'est pas essentiellement durcie.

10. Dispositif pour le collage temporaire d'un substrat de produit (1) avec un substrat porteur (4), présentant :
a) des moyens d'application pour l'application d'un adhésif de collage (3, 3') sur le substrat de produit (1) et/ou le substrat porteur (4) pour former une couche d'adhésif de collage (3, 3'),
b) des moyens de liaison pour la liaison du substrat porteur (4) avec le substrat de produit (1) par le biais de la couche d'adhésif de collage (3, 3'),
c) un dispositif de durcissement (10, 10') pour le durcissement d'une zone partielle (8, 8') seulement de la couche d'adhésif de collage (3, 3') après la liaison du substrat porteur (4) avec le substrat de produit (1), dans lequel une zone restante (9, 9') de la couche d'adhésif de collage (3, 3') n'est pas durcissable ou au moins n'est pas essentiellement durcissable.

11. Dispositif selon la revendication 10, dans lequel le dispositif de durcissement (10, 10') comprend une source d'irradiation (10), en particulier une source lumineuse aux UV (10).

12. Dispositif selon l'une des revendications précédentes, présentant un masque (5) entre la source d'irradiation (10) et les substrats (1, 4) pour occulter la zone partielle (9, 9').

13. Dispositif selon l'une des revendications précédentes, dans lequel le masque (5) présente une zone perméable (5a) pour l'irradiation de la source d'irradiation (10) et une zone non perméable (5b).

14. Dispositif selon l'une des revendications précédentes, dans lequel le dispositif de durcissement (10, 10') comprend une rangée (10') de sources lumineuses avec des sources lumineuses placées les unes à côté des autres, pouvant être commandées individuellement en particulier.
